# EUROPÄISCHE PATENTSCHRIFT

(11) **EP 2 652 785 B1**
(45) Veröffentlichungstag und Bekanntmachung des Hinweises auf die Patenterteilung: **12.07.2017**
(21) Anmeldenummer: 11794094.0
(22) Anmeldetag: 05.12.2011
(51) Int. Cl.: H01L 23/498, H01L 25/16, H01L 33/62, H01L 33/48

(54) **TRÄGER FÜR EINEN OPTOELEKTRONISCHEN HALBLEITERCHIP UND HALBLEITERCHIP**
SUPPORT FOR AN OPTOELECTRONIC SEMICONDUCTOR CHIP, AND SEMICONDUCTOR CHIP
SUPPORT POUR UNE PUCE SEMI-CONDUCTRICE OPTOÉLECTRONIQUE ET PUCE SEMI-CONDUCTRICE

(30) Priorität: 17.12.2010 DE 102010054898
(43) Veröffentlichungstag der Anmeldung: 23.10.2013
(73) Patentinhaber: OSRAM Opto Semiconductors GmbH, 93055 Regensburg (DE)
(72) Erfinder: HÖPPEL, Lutz, 93087 Alteglofsheim (DE)
(74) Vertreter: Epping - Hermann - Fischer
(86) Internationale Anmeldenummer: PCT/EP2011/071722
(87) Internationale Veröffentlichungsnummer: WO 2012/080015

(56) Entgegenhaltungen:
- EP-A1- 2 219 241
- WO-A1-2010/049852
- DE-A1-102008 024 443
- US-A1- 2005 151 246
- US-A1- 2007 090 510
- US-A1- 2010 164 120
- US-A1- 2010 213 498

## Beschreibung

Die vorliegende Anmeldung betrifft einen Träger für einen optoelektronischen Halbleiterchip sowie einen Halbleiterchip mit einem solchen Träger.

Zur Erzeugung von Strahlung vorgesehene Halbleiterkörper, beispielsweise Halbleiterkörper von Leuchtdioden, können auf Trägern angeordnet werden, bei denen die Halbleiterkörper durch den Träger hindurch über Durchführungen von der Rückseite des Halbleiterchips her elektrisch kontaktierbar sind. Solche Durchführungen können jedoch vergleichsweise hohe Serienwiderstände aufweisen, was einen effizienten Betrieb der Leuchtdiode erschwert. US 2005/151246 A1 offenbart einen Träger für einen elektronischen Halbleiterchip mit der Merkmalen des Oberbegriffs des Anspruchs 1. Eine Aufgabe ist es, einen Träger für einen optoelektronischen Halbleiterchip anzugeben, mit dem der optoelektronische Halbleiterchip verbesserte Eigenschaften aufweist.

Diese Aufgabe wird durch den Gegenstand des Patentanspruchs 1 gelöst. Ausgestaltungen und Weiterbildungen sind Gegenstand der abhängigen Patentansprüche.

Gemäß einer Ausführungsform weist ein Träger für einen optoelektronischen Halbleiterchip einen Trägerkörper mit einer ersten Hauptfläche und einer der ersten Hauptfläche gegenüberliegenden zweiten Hauptfläche auf. In dem Trägerkörper ist zumindest eine elektrische Durchkontaktierung ausgebildet, die sich von der ersten Hauptfläche zur zweiten Hauptfläche erstreckt. Auf der ersten Hauptfläche ist eine Isolationsschicht angeordnet, die die elektrische Durchkontaktierung nur bereichsweise bedeckt.

In Aufsicht auf den Träger überlappt die Isolationsschicht also mit der elektrischen Durchkontaktierung, bedeckt diese jedoch nicht vollständig. Die Isolationsschicht grenzt vorzugsweise zumindest bereichsweise unmittelbar an die erste Hauptfläche des Trägers an.

Insbesondere kann die Isolationsschicht eine Aussparung aufweisen, die in Aufsicht auf den Träger innerhalb der Durchkontaktierung ausgebildet ist.

Mittels der Aussparung ist die Größe des Bereichs des Trägers einstellbar, in dem die Durchkontaktierung seitens der ersten Hauptfläche für eine elektrisch leitende Verbindung zugänglich ist.

Die Durchkontaktierung erstreckt sich zweckmäßigerweise durch einen Durchbruch in dem Trägerkörper hindurch. Weiterhin besteht die Durchkontaktierung zweckmäßigerweise aus einem elektrisch leitfähigen Material, beispielsweise einem Metall oder einer metallischen Legierung.

Die Seitenwände des Durchbruchs sind vorzugsweise mit einer zweiten Isolationsschicht bedeckt. Die Durchkontaktierung kann so vom Trägerkörper elektrisch isoliert ausgebildet sein. Gemäß der Erfindung ist auf der dem Trägerkörper abgewandten Seite der Isolationsschicht eine Anschlussfläche ausgebildet, die mit der Durchkontaktierung elektrisch leitend verbunden ist.

Die Anschlussfläche ist zur elektrisch leitenden Verbindung mit einem optoelektronischen Halbleiterchip, beispielsweise einem zur Erzeugung von Strahlung vorgesehenen Halbleiterchip, etwa einer Leuchtdiode, vorgesehen. Gemäß der Erfindung ist auf der dem Trägerkörper abgewandten Seite der Isolationsschicht eine weitere Anschlussfläche ausgebildet, die die Durchkontaktierung bereichsweise überdeckt. Die weitere Anschlussfläche ist zweckmäßigerweise von der Anschlussfläche beabstandet.

Vorzugsweise ist in der weiteren Anschlussfläche eine Öffnung ausgebildet, in der die Anschlussfläche angeordnet ist. Aufgrund der Isolationsschicht kann eine Fläche der Öffnung kleiner sein als eine Fläche der Durchkontaktierung, ohne dass die Durchkontaktierung und der Durchbruch elektrisch miteinander verbunden sind. Mit anderen Worten ist die Größe der Öffnung unabhängig von der Größe der Durchkontaktierung einstellbar.

Zur Verringerung des Serienwiderstands der Durchkontaktierung kann also der Querschnitt der Durchkontaktierung in Aufsicht auf den Träger vergrößert werden, ohne dass der Querschnitt der Öffnung vergrößert werden muss.

In einer bevorzugten Ausgestaltung weist der Trägerkörper ein Halbleitermaterial auf. Insbesondere eignet sich Silizium aufgrund der guten Mikrostrukturierbarkeit und der kostengünstigen großflächigen Verfügbarkeit.

Der Trägerkörper weist vorzugsweise einen spezifischen Widerstand von mindestens 500 Ω cm auf, bevorzugt einen spezifischen Widerstand zwischen einschließlich 500 Ω cm und einschließlich 10.000 Ω cm, besonders bevorzugt zwischen einschließlich 1.000 und einschließlich 2.000 Ω cm.

Mit einem solchen hochohmigen Träger kann die Gefahr eines elektrischen Kurzschlusses bei der Montage des Trägers beziehungsweise eines Halbleiterchips mit einem solchen Träger vermieden werden.

Auf der zweiten Hauptfläche des Trägerkörpers ist vorzugsweise eine Kontaktfläche angeordnet, die elektrisch leitend mit der Durchkontaktierung verbunden ist. Die Kontaktfläche ist zur externen elektrischen Kontaktierung des Trägers beziehungsweise des Halbleiterchips mit einem solchen Träger vorgesehen. Gemäß der Erfindung weist der Träger eine weitere Durchkontaktierung auf. Die weitere Durchkontaktierung ist vorzugsweise auf der zweiten Hauptfläche des Trägerkörpers mit einer weiteren Kontaktfläche elektrisch leitend verbunden. Weiterhin ist die weitere Durchkontaktierung bevorzugt mit der weiteren Anschlussfläche auf der ersten Hauptfläche des Trägerkörpers elektrisch leitend verbunden.

Für eine externe elektrische Kontaktierung eines Halbleiterchips mit einem solchen Träger stehen auf der Rückseite des Halbleiterchips also zwei Kontaktflächen zur Verfügung. Eine Vorderseite des Halbleiterchips kann so auf einfache Weise frei von Kontaktflächen ausgebildet sein.

In einer bevorzugten Weiterbildung ist zwischen der Kontaktfläche und der zweiten Hauptfläche des Trägers eine dritte Isolationsschicht angeordnet.

Die Begriffe Isolationsschicht, zweite Isolationsschicht und dritte Isolationsschicht bedeuten nicht notwendigerweise, dass die Schichten in unterschiedlichen Herstellungsschritten hergestellt werden. Vielmehr können zwei oder mehr der beschriebenen Isolationsschichten in einem gemeinsamen Herstellungsschritt hergestellt werden und jeweils Teile einer gemeinsamen Schicht darstellen.

In einer bevorzugten Ausgestaltung weist der Träger eine Diodenstruktur auf. Vorzugsweise ist die Diodenstruktur in dem Trägerkörper ausgebildet. Mit anderen Worten ist die Diodenstruktur in den Trägerkörper integriert. Die Diodenstruktur kann beispielsweise zum Schutz vor elektrostatischer Entladung (electrostatic discharge, ESD) vorgesehen sein.

Die Diodenstruktur grenzt vorzugsweise an die zweite Hauptfläche des Trägerkörpers an. Insbesondere ist die Diodenstruktur zweckmäßigerweise mittels der Kontaktfläche und der weiteren Kontaktfläche elektrisch leitend verbunden, sodass die Diodenstruktur einen vorzugsweise unidirektionalen Ladungsträgerpfad zwischen der ersten Kontaktfläche und der weiteren Kontaktfläche bildet.

In einer bevorzugten Ausgestaltung weist die Diodenstruktur einen ersten Teilbereich eines ersten Leitungstyps auf. In Aufsicht auf den Träger ist der erste Teilbereich bevorzugt von den Seitenflächen des Trägers beabstandet. Weiterhin bevorzugt weist die Diodenstruktur einen zweiten Teilbereich eines vom ersten Leitungstyp verschiedenen zweiten Leitungstyps auf, wobei der erste Teilbereich den zweiten Teilbereich in Aufsicht auf den Halbleiterchip bevorzugt umschließt. Insbesondere kann der erste Teilbereich als ein wannenförmiger Teilbereich innerhalb des Trägerkörpers ausgebildet sein, wobei der zweite Teilbereich vollständig innerhalb des ersten Teilbereichs ausgebildet ist. Der zweite Teilbereich ist also von dem übrigen Teil des Trägerkörpers vollständig durch den ersten Teilbereich getrennt.

Der Träger ist vorzugsweise in einem Trägerverbund ausgebildet, der für die Herstellung einer Mehrzahl von Halbleiterchips mit jeweils einem Träger aus dem Trägerverbund vorgesehen ist. Das heißt, der Träger des Halbleiterchips geht bei der Herstellung der Halbleiterchips aus einer Vereinzelung des Trägerverbunds hervor, nachdem die Halbleiterkörper der Halbleiterchips bereits an den jeweiligen Trägern befestigt sind.

Ein Halbleiterchip mit einem beschriebenen Träger weist vorzugsweise einen Halbleiterkörper auf, der seitens der ersten Hauptfläche auf dem Träger angeordnet und elektrisch leitend mit der Anschlussfläche verbunden ist. Der Halbleiterkörper kann beispielsweise einen zur Erzeugung oder zum Empfang von Strahlung vorgesehenen aktiven Bereich aufweisen.

In einer bevorzugten Ausgestaltung ist ein Aufwachssubstrat für eine Halbleiterschichtenfolge des Halbleiterkörpers entfernt. Nach dem Befestigen des Halbleiterkörpers an dem Träger dient dieser der mechanischen Stabilisierung des Halbleiterkörpers, sodass das Aufwachssubstrat hierfür nicht mehr erforderlich ist und entfernt werden kann.

In einer bevorzugten Ausgestaltung liegt eine Seitenfläche des Trägerkörpers frei. Ein solcher Halbleiterchip ist vereinfacht herstellbar, da der aus dem Trägerverbund hervorgehende Träger nach dem Vereinzeln an den Seitenflächen nicht mehr beschichtet werden muss.

Weitere Merkmale, Ausgestaltungen und Zweckmäßigkeiten ergeben sich aus der folgenden Beschreibung der Ausführungsbeispiele in Verbindung mit den Figuren.

Es zeigen:
- die Figuren 1A und 1B: ein erstes Ausführungsbeispiel für einen Träger in schematischer Aufsicht (Figur 1B) und zugehöriger Schnittansicht (Figur 1A);
- Figur 2: ein Ausführungsbeispiel für einen Halbleiterchip mit einem Träger in schematischer Schnittansicht; und
- Figur 3: eine schematische Darstellung möglicher Strompfade in dem Halbleiterchip gemäß dem in Figur 2 dargestellten Ausführungsbeispiel.

Gleiche, gleichartige oder gleich wirkende Elemente sind in den Figuren mit denselben Bezugszeichen versehen.

Die Figuren und die Größenverhältnisse der in den Figuren dargestellten Elemente untereinander sind nicht als maßstäblich zu betrachten. Vielmehr können einzelne Elemente zur verbesserten Darstellbarkeit und/oder zum besseren Verständnis übertrieben groß dargestellt sein.

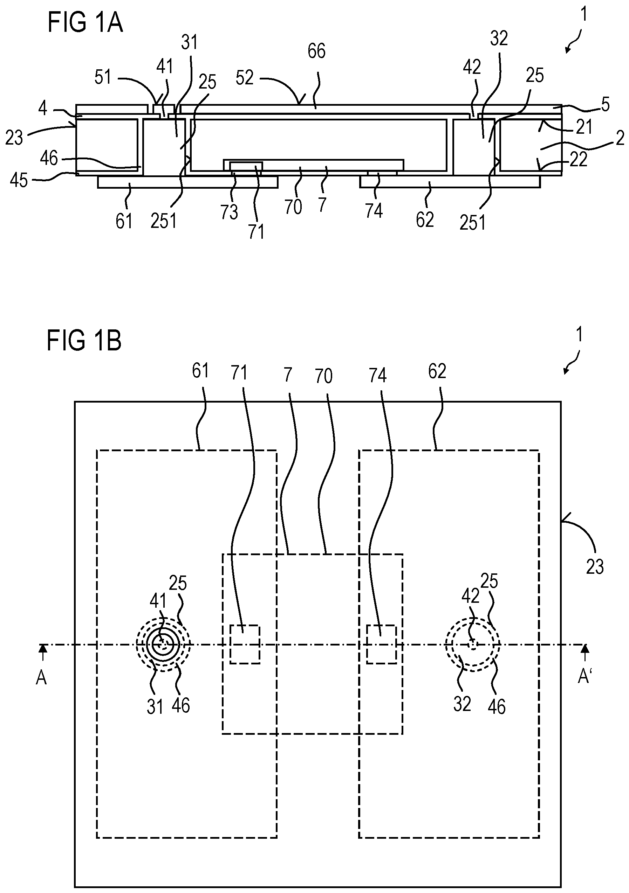

Ein Träger 1 gemäß dem in den Figuren 1A und 1B dargestellten Ausführungsbeispiel weist einen Trägerkörper 2 mit einer ersten Hauptfläche 21 und einer der ersten Hauptfläche gegenüberliegenden, parallel zur erste Hauptfläche verlaufenden, zweiten Hauptfläche 22 auf. Die Hauptflächen begrenzen den Trägerkörper in vertikaler Richtung, also senkrecht zur ersten Hauptfläche 21 des Trägerkörpers 2. In dem Träger 1 sind Durchbrüche 25 ausgebildet, die sich in vertikaler Richtung durch den Trägerkörper 2 hindurch erstrecken.

In einem der Durchbrüche 25 ist eine Durchkontaktierung 31 ausgebildet, die sich von der ersten Hauptfläche 21 zur zweiten Hauptfläche 22 des Trägerkörpers erstreckt. Seitens der ersten Hauptfläche 21 ist die Durchkontaktierung mit einer Anschlussfläche 51 elektrisch leitend verbunden. Die Anschlussfläche 51 grenzt bereichsweise unmittelbar an die Durchkontaktierung 31 an.

Auf der ersten Hauptfläche 21 des Trägerkörpers 2 ist eine Isolationsschicht 4 ausgebildet, die die Durchkontaktierung bereichsweise überdeckt. In der Isolationsschicht 4 ist eine Aussparung 41 ausgebildet, die in Aufsicht auf den Träger 1 mit der Durchkontaktierung 31 überlappt. Insbesondere verläuft die Aussparung innerhalb der Durchkontaktierung. Die Isolationsschicht 4 verläuft in vertikaler Richtung bereichsweise zwischen der Anschlussfläche 51 und der Durchkontaktierung 31.

Seitens der zweiten Hauptfläche 22 des Trägerkörpers 2 ist die Durchkontaktierung 31 elektrisch leitend mit einer Kontaktfläche 61 verbunden. Die Kontaktfläche 61 ist zur externen elektrischen Kontaktierung des Trägers 1 vorgesehen.

Weiterhin weist der Träger eine weitere Durchkontaktierung 32 auf, die seitens der ersten Hauptfläche 21 elektrisch leitend mit einer weiteren Anschlussfläche 52 verbunden ist. Die Durchkontaktierungen 31, 32 sind in lateraler Richtung voneinander beabstandet.

Seitens der zweiten Hauptfläche 22 ist die Durchkontaktierung mit einer weiteren Kontaktfläche 62 elektrisch leitend verbunden.

Zwischen den Durchkontaktierungen 31, 32 und dem Trägerkörper 2 ist jeweils eine zweite Isolationsschicht 46 ausgebildet, die die Durchkontaktierungen von dem Trägerkörper elektrisch isoliert. Die zweite Isolationsschicht bedeckt die Seitenwände 251 der Durchbrüche 25.

Auf der zweiten Hauptfläche ist eine dritte Isolationsschicht 45 ausgebildet, die bereichsweise zwischen dem Trägerkörper 2 und der Kontaktfläche 61 sowie bereichsweise zwischen dem Trägerkörper und der weiteren Kontaktfläche 62 verläuft.

Die Anschlussfläche 51 und die weitere Anschlussfläche 52 sind vorzugsweise als Teile einer gemeinsamen Verbindungsschicht 5 ausgebildet. Die weitere Anschlussfläche 52 weist eine Öffnung auf, innerhalb derer die Anschlussfläche 51 ausgebildet ist. Ein Querschnitt der Öffnung ist kleiner als ein Querschnitt des Durchbruchs 25.

Durch die Isolationsschicht 4 ist gewährleistet, dass zwischen der weiteren Anschlussfläche 52 und der Durchkontaktierung 31 kein unmittelbarer elektrischer Kontakt besteht.

Der minimale Querschnitt der Öffnung ist aufgrund der Isolationsschicht 4 also nicht durch den Querschnitt des Durchbruchs 25 oder der Durchkontaktierung 31 vorgegeben, sondern durch den Querschnitt der Aussparung 41 in der Isolationsschicht 4.

Bei gleichem Querschnitt der Öffnung kann also der Querschnitt der Durchkontaktierung 31 erhöht werden, wodurch sich der Serienwiderstand der Durchkontaktierung verringert. Zur Erzielung hinreichend niedriger Serienwiderstände kann für die Durchkontaktierung daher auch ein Material Anwendung finden, das eine niedrigere elektrische Leitfähigkeit aufweist als das vergleichsweise teure Gold.

Beispielsweise kann die Durchkontaktierung 31 Aluminium, Silber, Kupfer oder eine metallische Legierung, die zumindest eines der genannten Materialien oder Gold enthält, beispielsweise eine Gold-Zinn-Legierung, enthalten oder aus einem solchen Material bestehen.

In der Isolationsschicht 4 ist eine weitere Aussparung 42 ausgebildet, die mit der weiteren Durchkontaktierung 32 überlappt. Die weitere Aussparung 42 der Isolationsschicht 4 kann der Aussparung 41 entsprechend ausgebildet sein. Davon abweichend kann der Querschnitt der weiteren Aussparung 42 auch größer sein als der Querschnitt der Aussparung 41. Zweckmäßigerweise ist der Querschnitt der weiteren Aussparung jedoch kleiner als der Querschnitt der weiteren Durchkontaktierung 32.

Eine den Träger 1 in lateraler Richtung begrenzende Seitenfläche 23 liegt frei, ist also nicht durch eine Isolationsschicht bedeckt. Bei der Herstellung des Trägers durch Vereinzelung aus einem Trägerverbund kann die Seitenfläche so direkt beim Vereinzeln gebildet werden. Ein nachträgliches Aufbringen einer Isolationsschicht auf den bereits vereinzelten Trägern kann so vermieden werden.

Der Trägerkörper 2 weist vorzugsweise ein Halbleitermaterial auf. Insbesondere Silizium eignet sich aufgrund seiner guten Mikrostrukturierbarkeit, der vergleichsweise hohen thermischen Leitfähigkeit und zeichnet sich weiterhin durch eine großflächige und kostengünstige Verfügbarkeit aus.

Der Trägerkörper 2 weist vorzugsweise einen spezifischen Widerstand von mindestens 500 Ω cm auf, bevorzugt einen spezifischen Widerstand zwischen einschließlich 500 Ω cm und einschließlich 10.000 Ω cm, besonders bevorzugt zwischen einschließlich 1.000 und einschließlich 2.000 Ω cm. Durch einen hinreichend hohen spezifischen Widerstand kann die Gefahr eines elektrischen Kurzschlusses bei der Montage des Trägers, auch bei den freiliegenden Seitenflächen 23 des Trägers, beispielsweise aufgrund eines an die Seitenflächen des Trägerkörpers angrenzenden Lots oder elektrisch leitfähigen Klebemittels, vermieden werden.

In dem Trägerkörper 2 ist eine Diodenstruktur 7 integriert ausgebildet. Die Diodenstruktur 7 grenzt an die zweite Hauptfläche 2 des Trägerkörpers 2 an.

Die Diodenstruktur 7 weist einen ersten Teilbereich 70 eines ersten Leitungstyps auf. In Aufsicht auf den Halbleiterchip überlappt der erste Teilbereich mit der Kontaktfläche 61 und der weiteren Kontaktfläche 62. Durch die Ausbildung der Diodenstruktur im Bereich der zweiten Hauptfläche 22 kann diese auf einfache Weise hinsichtlich deren Geometrie weitgehend unabhängig von der Ausgestaltung der Durchkontaktierungen und der an die erste Hauptfläche angrenzenden Isolationsschicht 4 ausgestaltet sein. Die Diodenstruktur kann so vergleichsweise großflächig umgesetzt werden.

In Aufsicht auf den Träger ist innerhalb des ersten Teilbereichs 70 ein zweiter Teilbereich 71 eines vom ersten Leitungstyp verschiedenen zweiten Leitungstyps ausgebildet. Vorzugsweise ist der erste Teilbereich p-leitend und der zweite Teilbereich n-leitend ausgebildet. Der zweite Teilbereich überlappt in Aufsicht auf den Träger 1 nur mit einer der Kontaktflächen, in dem gezeigten Ausführungsbeispiel mit der Kontaktfläche 61. Der zweite Teilbereich 71 ist mittels eines Diodenanschlusses 73 mit der Kontaktfläche 61 elektrisch leitend verbunden.

Der erste Teilbereich 70 ist mittels eines weiteren Diodenanschlusses 74 elektrisch leitend mit der weiteren Kontaktfläche 62 verbunden.

Die Teilbereiche 70, 71 können beispielsweise durch IonenImplantation im Trägerkörper 2 ausgebildet werden.

Die Diodenanschlüsse 73, 74 sind zweckmäßigerweise mittels eines Metalls gebildet, das zum Material des ersten Teilbereichs beziehungsweise des zweiten Teilbereichs der Diodenstruktur 7 einen hinreichend guten elektrischen Kontakt bildet. Beispielsweise können die Diodenanschlüsse Aluminium enthalten.

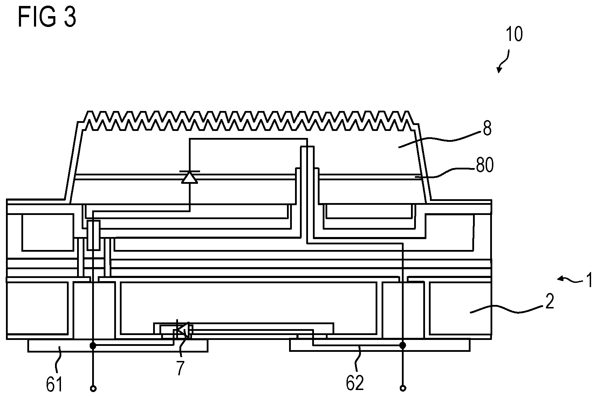

Die Funktionsweise der Diodenstruktur wird im Zusammenhang mit Figur 3 näher erläutert.

Für die Kontaktflächen 61, 62 sowie die Anschlussflächen 51, 52 eignen sich insbesondere Materialien, zu denen eine elektrisch leitende Verbindung vereinfacht herstellbar ist, beispielsweise mittels Lötens.

Beispielsweise können die Kontaktflächen und/oder die Anschlussflächen Titan, Platin, Gold, Silber, Nickel oder Wolfram oder eine metallische Legierung mit zumindest einem der genannten Materialien enthalten oder aus einem solchen Material bestehen. Insbesondere können die genannten Flächen auch mehrschichtig ausgebildet sein.

Für die Isolationsschichten 4, 45, 46 eignet sich insbesondere ein Oxid, beispielsweise Siliziumoxid, ein Nitrid, beispielsweise Siliziumnitrid, oder ein Oxinitrid, beispielsweise Siliziumoxinitrid.

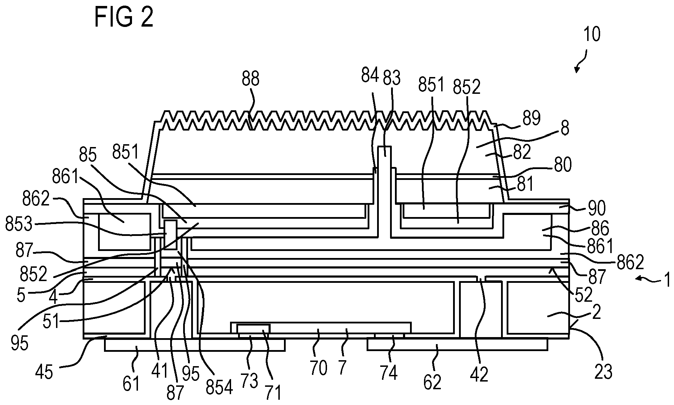

Ein Ausführungsbeispiel für einen Halbleiterchip ist in Figur 2 schematisch in Schnittansicht dargestellt. Der Halbleiterchip 10 weist einen Träger 1 auf, der wie im Zusammenhang mit den Figuren 1A und 1B beschrieben ausgeführt ist. Weiterhin umfasst der Halbleiterchip einen Halbleiterkörper 8 mit einer Halbleiterschichtenfolge, die einen zur Erzeugung von Strahlung vorgesehenen aktiven Bereich 80 aufweist, der zwischen einer ersten Halbleiterschicht 81 und einer zweiten Halbleiterschicht 82 angeordnet ist.

Der Halbleiterkörper 8, insbesondere der aktive Bereich 80, enthält vorzugsweise ein III-V-Verbindungshalbleitermaterial. III-V-Halbleitermaterialien sind zur Strahlungserzeugung im ultravioletten (Alₓ In_{y} Ga_{1-x-y} N) über den sichtbaren (Alₓ In_{y} Ga_{1-x-y} N, insbesondere für blaue bis grüne Strahlung, oder Alₓ In_{y} Ga_{1-x-y} P, insbesondere für gelbe bis rote Strahlung) bis in den infraroten (Alₓ In_{y} Ga_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Von dem beschriebenen Ausführungsbeispiel abweichend kann der Halbleiterchip 1 auch als ein Strahlungsempfänger ausgebildet sein.

Von der dem Träger 1 zugewandten Seite her ist in dem Halbleiterkörper 8 eine Ausnehmung 83 ausgebildet, die sich durch den aktiven Bereich 80 hindurch in die zweite Halbleiterschicht 82 hinein erstreckt, sodass diese Halbleiterschicht von der dem Träger zugewandten Seite her elektrisch kontaktierbar ist. Die Ausnehmung ist in lateraler Richtung von einer Seitenfläche des Halbleiterkörpers 8 beabstandet. Zur Vermeidung eines elektrischen Kurzschlusses ist eine Seitenfläche der Ausnehmung 83 zumindest bereichsweise mittels einer vierten Isolationsschicht 84 bedeckt. Vorzugsweise weist der Halbleiterkörper 83 eine Mehrzahl von Ausnehmungen 83 auf. Eine in lateraler Richtung gleichmäßige Injektion von Ladungsträgern über die zweite Halbleiterschicht 82 in den aktiven Bereich 80 ist so auf einfache Weise realisiert.

Die zweite Halbleiterschicht 82 ist über einen zweiten Anschlussbereich 86 elektrisch leitend mit der weiteren Anschlussfläche 52 des Trägers 1 verbunden. Der zweite Anschlussbereich weist in diesem Ausführungsbeispiel exemplarisch eine erste Schicht 861 auf, die sich durch die Ausnehmung 83 hindurch bis zur zweiten Halbleiterschicht 82 erstreckt. Auf der dem Halbleiterkörper abgewandten Seite der ersten Schicht ist eine zweite Schicht 862 ausgebildet, die die erste Schicht vollständig umgibt. Die erste Halbleiterschicht 81 ist über einen ersten Anschlussbereich 85 mit der Anschlussfläche 51 elektrisch leitend verbunden.

Ein Aufwachssubstrat für die Halbleiterschichtenfolge des Halbleiterkörpers 8 ist entfernt. Nach der Montage des Halbleiterkörpers an dem Träger 1 dient dieser der mechanischen Stabilisierung des Halbleiterkörpers.

Der erste Anschlussbereich 85 ist bereichsweise zwischen dem zweiten Anschlussbereich 86 und dem Halbleiterkörper 8 angeordnet. Weiterhin ist zwischen dem ersten Anschlussbereich 85 und dem zweiten Anschlussbereich 86 eine fünfte Isolationsschicht 90 ausgebildet, die die Anschlussbereiche elektrisch voneinander isoliert. Der erste Anschlussbereich ist ähnlich dem zweiten Anschlussbereich 86 mehrschichtig ausgebildet und weist vom Halbleiterkörper 8 aus gesehen eine erste Schicht 851, eine zweite Schicht 852, eine dritte Schicht 853 und eine vierte Schicht 854 auf.

Die an den Halbleiterkörper unmittelbar angrenzenden Schichten, also die erste Schicht 851 des ersten Anschlussbereichs 85 und die erste Schicht 861 des zweiten Anschlussbereichs 86 weisen vorzugsweise für die in aktiven Bereich 80 erzeugte Strahlung eine hohe Reflektivität auf. Insbesondere eignet sich Silber für Strahlung im sichtbaren Spektralbereich. Alternativ kann beispielsweise aber auch Aluminium, Nickel, Rhodium oder Palladium Anwendung finden.

Mittels der zweiten Schichten 852, 862 der Anschlussbereiche 85 beziehungsweise 86 kann die jeweils zugehörige erste Schicht gekapselt werden, sodass beispielsweise eine Oxidation oder eine Migration von Material der ersten Schicht, beispielsweise Silber, vermieden wird.

Die beschriebenen Schichten des ersten und zweiten Anschlussbereichs können jeweils zumindest teilweise in gemeinsamen Herstellungsschritten abgeschieden werden.

Auf der dem Träger 1 zugewandten Seite ist eine weitere Verbindungsschicht 87 ausgebildet, die zur elektrisch leitenden und mechanisch stabilen Verbindung mit der Verbindungsschicht 5 des Trägers 1 vorgesehen ist. Für die Verbindungsschicht und die weitere Verbindungsschicht eignet sich insbesondere ein Lot, das beispielsweise zumindest eines der Materialien Titan, Gold oder Zinn aufweist.

Zwischen dem ersten Anschlussbereich 85 und dem zweiten Anschlussbereich 86 ist ein Zwischenraum 95 ausgebildet, der sich auch durch die Verbindungsschichten 5, 87 hindurch erstreckt und der elektrischen Isolation dient.

Im Betrieb des Halbleiterchips können bei Anlegen einer externen elektrischen Spannung zwischen der Kontaktfläche 61 und der weiteren Kontaktfläche 62 Ladungsträger von verschiedenen Seiten in den aktiven Bereich 80 emittiert werden und dort unter Emission von Strahlung rekombinieren. Die externe Kontaktierung kann ausschließlich von der Rückseite des Halbleiterchips, also seitens der zweiten Hauptfläche 22 des Trägers, erfolgen. Die Vorderseite des Halbleiterchips kann dagegen vollständig frei von externen Kontaktflächen für den Halbleiterchip sein, sodass eine Abschattung der im aktiven Bereich 80 erzeugten Strahlung vermieden wird.

Zur Erhöhung der Auskoppelkoeffizienz der erzeugten Strahlung weist die vom Träger 1 abgewandte vorderseitige Strahlungsaustrittsfläche eine Strukturierung 88 auf, die regelmäßig oder unregelmäßig, beispielsweise als eine Aufrauung, ausgebildet sein kann.

Auf dem Halbleiterkörper 8 ist eine Passivierung 89 ausgebildet, die insbesondere die vorderseitige Strahlungsaustrittsfläche und die Seitenflächen des Halbleiterkörpers 8 bedeckt und vor widrigen äußeren Umwelteinflüssen schützt.

Mögliche Strompfade in einem Halbleiterchip gemäß dem in Figur 2 dargestellten Ausführungsbeispiel sind in Figur 3 schematisch für den Fall gezeigt, dass die erste Halbleiterschicht 81 p-leitend und die zweite Halbleiterschicht 82 n-leitend ausgebildet ist.

Durch Anlegen einer positiven Spannung an der Kontaktfläche 61 relativ zur weiteren Kontaktfläche 62 werden Ladungsträger in Durchlassrichtung in den aktiven Bereich 80 injiziert und können dort unter Emission von Strahlung rekombinieren. Der pn-Übergang zwischen dem ersten Teilbereich und dem zweiten Teilbereich der Diodenstruktur 7 ist bezüglich ihrer Durchlassrichtung antiparallel zum aktiven Bereich geschaltet. In dieser Polarität der anliegenden Spannung ist die Diodenstruktur daher in Sperrrichtung orientiert, sodass im regulären Betrieb des Halbleiterchips über diesen Strompfad kein signifikanter Stromfluss erfolgt.

Wenn dagegen an der weiteren Kontaktfläche 62 relativ zur Kontaktfläche 61 eine positive Spannung anliegt, beispielsweise aufgrund einer elektrostatischen Aufladung, können die Ladungsträger über die Diodenstruktur 7 durch einen Strompfad innerhalb des Trägers 1, insbesondere innerhalb des Trägerkörpers 2, abfließen. Die Gefahr einer Schädigung des aktiven Bereichs aufgrund einer hohen, in Sperrrichtung anliegenden Spannung kann so vermieden werden. Durch die Ausgestaltung der Diodenstruktur 7 an der zweiten Hauptfläche des Trägers 22 kann diese auf einfache Weise großflächig ausgestaltet sein, wodurch ein zuverlässiger ESD-Schutz auch bei hohen anliegenden Spannungen gegeben ist.

Bei einem solchen Halbleiterchip ist also die Funktionalität einer ESD-Schutzdiode bereits in den Träger des Halbleiterchips integriert, sodass auf zusätzliche, außerhalb des Halbleiterchips anzuordnende Schutzdioden verzichtet werden kann.

Bei der Herstellung der Halbleiterchips werden die Halbleiterkörper also so auf einem Trägerverbund angeordnet, dass jedem Halbleiterkörper eine Diodenstruktur zugeordnet ist. Beim Vereinzeln in Halbleiterchips sind diese also schon vor einer ESD-Schädigung geschützt.

Die Erfindung ist nicht durch die Beschreibung anhand der Ausführungsbeispiele beschränkt. Die Erfindung ist durch die Patentansprüche definiert.

## Patentansprüche

1. Träger (1) für einen optoelektronischen Halbleiterchip (10), wobei
- der Träger einen Trägerkörper (2) mit einer ersten Hauptfläche (21) und einer der ersten Hauptfläche gegenüberliegenden zweiten Hauptfläche (22) aufweist;
- in dem Trägerkörper zumindest eine erste elektrische Durchkontaktierung (31) ausgebildet ist, die sich von der ersten Hauptfläche zur zweiten Hauptfläche erstreckt; und
- auf der ersten Hauptfläche eine Isolationsschicht (4) angeordnet ist, die die erste elektrische Durchkontaktierung nur bereichsweise bedeckt;
- auf der dem Trägerkörper abgewandten Seite der Isolationsschicht eine Anschlussfläche (51) ausgebildet ist, die mit ersten Durchkontaktierung elektrisch leitend verbunden ist;
- der Träger eine weitere Durchkontaktierung (32) aufweist, die seitens der ersten Hauptfläche des Trägerkörpers mit einer weiteren Anschlussfläche (52) elektrisch leitend verbunden ist;
**dadurch gekennzeichnet, dass**
- die weitere Anschlussfläche (52) auf der dem Trägerkörper abgewandten Seite der Isolationsschicht (4) ausgebildet ist und die erste Durchkontaktierung (31) bereichsweise überdeckt, wobei zwischen der weiteren Anschlussfläche(52) und der ersten Durchkontaktierung (31)kein unmittelbarer elektrischer Kontakt besteht.

2. Träger nach Anspruch 1,
wobei der Trägerkörper ein Halbleitermaterial aufweist.

3. Träger nach Anspruch 1 oder 2,
wobei der Trägerkörper einen spezifischen Widerstand von mindestens 500 Ω cm aufweist.

4. Träger nach einem der vorangegangenen Ansprüche,
wobei auf der zweiten Hauptfläche des Trägerkörpers eine Kontaktfläche (61) angeordnet ist, die elektrisch leitend mit der ersten Durchkontaktierung verbunden ist.

5. Träger nach einem der vorangegangenen Ansprüche,
wobei zwischen der Kontaktfläche und der zweiten Hauptfläche eine weitere Isolationsschicht (45) angeordnet ist.

6. Träger nach einem der vorangegangenen Ansprüche, wobei die weitere Durchkontaktierung (32) auf der zweiten Hauptfläche des Trägerkörpers mit einer weiteren Kontaktfläche (62) elektrisch leitend verbunden ist.

7. Träger nach einem der vorangegangenen Ansprüche,
wobei in dem Trägerkörper eine Diodenstruktur (7) ausgebildet ist, die an die zweite Hauptfläche des Trägerkörpers angrenzt.

8. Träger nach Anspruch 7,
wobei die Diodenstruktur einen ersten Teilbereich (70) eines ersten Leitungstyps aufweist, der einen zweiten Teilbereich (71) eines zweiten Leitungstyps in Aufsicht auf den Halbleiterchip umschließt.

9. Träger nach einem der Ansprüche 1 bis 3,
wobei
- auf der zweiten Hauptfläche des Trägerkörpers eine Kontaktfläche (61), die mit der ersten Durchkontaktierung elektrisch leitend verbunden ist, angeordnet ist;
- in dem Trägerkörper eine Diodenstruktur (7) ausgebildet ist, die an die zweite Hauptfläche des Trägerkörpers angrenzt;
- die Kontaktfläche und die weitere Kontaktfläche in Aufsicht auf den Träger mit der Diodenstruktur überlappen; und
- die Kontaktfläche und die weitere Kontaktfläche über die Diodenstruktur miteinander verbunden sind.

10. Träger nach einem der vorangegangenen Ansprüche,
wobei der Träger in einem Trägerverbund ausgebildet ist, der für die Herstellung einer Mehrzahl von Halbleiterchips mit jeweils einem Träger aus dem Trägerverbund vorgesehen ist.

11. Halbleiterchip (10) mit einem Träger (1) nach einem der Ansprüche 1 bis 9, wobei auf dem Träger seitens der ersten Hauptfläche ein Halbleiterkörper (8) mit einem zur Erzeugung von Strahlung vorgesehenen aktiven Bereich (80) angeordnet und elektrisch leitend mit der Anschlussfläche (51) verbunden ist.

12. Halbleiterchip nach Anspruch 11,
bei dem ein Aufwachssubstrat für die Halbleiterschichtenfolge des Halbleiterkörpers entfernt ist.

13. Halbleiterchip nach Anspruch 11 oder 12,
bei dem eine Seitenfläche (23) des Trägerkörpers freiliegt.

14. Halbleiterchip nach einem der Ansprüche 11 bis 13,
wobei in dem Halbleiterkörper von der dem Träger zugewandten Seite her eine Ausnehmung (83) ausgebildet ist, die sich durch den aktiven Bereich hindurch erstreckt.

## Claims

1. A support (1) for an optoelectronic semiconductor chip (10), wherein
- the support has a support body (2) having a first main face (21) and a second main face (22) opposite the first main face;
- at least one first electrical plated-through hole (31) extending from the first main face to the second main face is formed in the support body; and
- an insulation layer (4) is arranged on the first main face, said insulation layer covering the first electrical plated-through hole only in regions;
- a connection area (51) is formed on that side of the insulation layer which faces away from the support body, said connection area being electrically conductively connected to the first plated-through hole;
- the support has a further plated-through hole (32), which is electrically conductively connected to a further contact area (62) on the second main face of the support body;
**characterized in that**
the further connection area (52) is formed on the side of the insulation layer (4) facing away from the support body and covers the first plated-through hole (31) in regions, wherein there is no direct electrical contact between the further connection area (52) and the first plated-through hole (31).

2. The support according to claim 1,
wherein the support body comprises a semiconductor material.

3. The support according to claim 1 or 2,
wherein the support body has a resistivity of at least 500 Ω cm.

4. The support according to any of the preceding claims,
wherein a contact area (61) is arranged on the second main face of the support body, said contact area being electrically conductively connected to the first plated-through hole.

5. The support according to any of the preceding claims,
wherein a further insulation layer (45) is arranged between the contact area and the second main face.

6. The support according to any of the preceding claims,
wherein the further plated-through hole is electrically conductively connected to a further contact area (62) on the second main face of the support body.

7. The support according to any of the preceding claims,
wherein a diode structure (7) is formed in the support body, said diode structure adjoining the second main face of the support body.

8. The support according to claim 7,
wherein the diode structure has a first partial region (70) of a first conduction type, which encloses a second partial region (71) of a second conduction type in a plan view of the semiconductor chip.

9. The support according to any of claims 1 to 3, wherein
- a contact area (61) electrically conductively connected to the first plated-through hole is arranged on the second main face;
- a diode structure (7) is formed in the support body, said diode structure adjoining the second main face of the support body;
- the contact area and the further contact area overlap the diode structure in a plan view of the support; and
- the contact area and the further contact area are connected to one another via the diode structure.

10. The support according to any of the preceding claims,
wherein the support is formed in a support assemblage provided for the production of a plurality of semiconductor chips each comprising a support from the support assemblage.

11. A semiconductor chip (10) comprising a support (1) according to any of claims 1 to 10, wherein a semiconductor body (8) having an active region (80) provided for generating radiation is arranged on the support on the part of the first main face and is electrically conductively connected to the connection area (51).

12. The semiconductor chip according to claim 11, wherein a growth substrate for the semiconductor layer sequence of the semiconductor body is removed.

13. The semiconductor chip according to claim 11 or 12,
wherein a side face (23) of the support body is exposed.

14. The semiconductor chip according to any of claims 11 to 13,
wherein a recess (83) extending through the active region is formed in the semiconductor body from a side facing the support.

## Revendications

1. Support (1) pour une puce semi-conductrice (10) optoélectronique,
- le support comportant un corps de support (2) avec une première surface principale (21) et une deuxième surface principale (22) opposée à la première surface principale,
- dans le corps de support étant conçu au moins un premier via (31) électrique, qui s'étend de la première surface principale vers la deuxième surface principale ; et
- sur la première surface principale étant placée une couche isolante (4) qui ne recouvre que par endroits le premier via électrique ;
- sur la face de la couche isolante qui est opposée au corps de support étant conçue une surface de raccordement (51) qui est reliée de manière conductrice d'électricité avec le premier via ;
- le support comportant un via (32) supplémentaire qui, sur le côté de la première surface principale du corps de support est relié de manière conductrice d'électricité avec une surface de raccordement (52) supplémentaire ;
**caractérisé en ce que**
- la surface de raccordement (52) supplémentaire est conçue sur la face de la couche isolante (4) qui est opposée au corps de support et recouvre par endroits le premier via (31), alors qu'entre la surface de raccordement (52) supplémentaire et le premier via (31), il n'existe aucun contact électrique direct.

2. Support selon la revendication 1,
le corps de support comportant une matière semi-conductrice.

3. Support selon la revendication 1 ou 2,
le corps de support faisant preuve d'une résistance spécifique d'au moins 500 Ω.

4. Support selon l'une quelconque des revendications précédentes, sur la deuxième surface principale du corps de support étant placée une surface de contact (61) qui est reliée de manière conductrice d'électricité avec le premier via.

5. Support selon l'une quelconque des revendications précédentes, entre la surface de contact et la deuxième surface principale étant placée une couche isolante (45) supplémentaire.

6. Support selon l'une quelconque des revendications précédentes, sur la deuxième surface principale du corps de support, le via (32) supplémentaire étant relié de manière conductrice d'électricité avec une surface de contact (62) supplémentaire.

7. Support selon l'une quelconque des revendications précédentes, dans le corps de support étant conçue une structure à diodes (7) qui est adjacente à la deuxième surface principale du corps de support.

8. Support selon la revendication 7,
la structure à diodes comportant une première zone partielle (70) d'un premier type de conductivité qui, vue en élévation sur la puce semi-conductrice, entoure une deuxième zone partielle (71) d'un deuxième type de conductivité.

9. Support selon l'une quelconque des revendications 1 à 3,
- sur la deuxième surface principale du corps de support étant placée une surface de contact (61) qui est reliée de manière conductrice d'électricité avec le premier via ;
- dans le corps de support étant conçue une structure à diodes (7) qui est adjacente à la deuxième surface principale du corps de support ;
- vues en élévation sur le support, la surface de contact et la surface de contact supplémentaire se chevauchant avec la structure à diodes ; et
- la surface de contact et la surface de contact supplémentaire étant reliées l'une à l'autre par l'intermédiaire de la structure à diodes.

10. Support selon l'une quelconque des revendications précédentes,
le support étant conçu dans un assemblage de supports qui est prévu pour la fabrication d'une pluralité de puces semi-conductrices, avec chacune un support de l'assemblage de supports.

11. Puce semi-conductrice (10) avec un support (1) selon l'une quelconque des revendications 1 à 9, sur le support, du côté de la première surface principale étant placé un corps semi-conducteur (8) avec une zone active (80) prévue pour générer un rayonnement et étant relié de manière conductrice d'électricité avec la surface de raccordement (51).

12. Puce semi-conductrice selon la revendication 11, sur laquelle un substrat d'épitaxie est retiré pour la succession de couches semi-conductrices du corps semi-conducteur.

13. Puce semi-conductrice selon la revendication 11 ou 12,
sur laquelle une surface latérale (23) du corps de support est dénudée.

14. Puce semi-conductrice selon l'une quelconque des revendications 11 à 13,
dans le corps semi-conducteur, à partir du côté faisant face au support étant conçu un évidement (83) qui s'étend à travers la zone active.
